# EUROPEAN PATENT APPLICATION

(11) **EP 4 040 495 A1**
(43) Date of publication of application: **10.08.2022**
(21) Application number: 22153642.8
(22) Date of filing: 27.01.2022
(51) Int. Cl.: H01L 27/15, H01L 33/62

(54) **LIGHT-EMITTING DEVICE AND DISPLAY APPARATUS INCLUDING THE SAME**

(30) Priority: 03.02.2021 US 202163145166 P; 03.05.2021 KR 20210057479
(71) Applicant: Samsung Electronics Co., Ltd., Gyeonggi-do 16677 (KR)
(72) Inventor: HWANG, Kyungwook, 16678, Suwon-si, (KR); HONG, Seogwoo, 16678, Suwon-si, (KR); HWANG, Junsik, 16678, Suwon-si, (KR); KIM, Dongho, 16678, Suwon-si, (KR); KIM, Hyunjoon, 16678, Suwon-si, (KR); PARK, Joonyong, 16678, Suwon-si, (KR)
(74) Representative: Elkington and Fife LLP

(57) **Abstract**

Provided is a light-emitting device including a plurality of light-emitting cells, each of the plurality of light-emitting cells being configured to independently emit light, a common semiconductor layer provided on the plurality of light-emitting cells, a first electrode provided on the common semiconductor layer, and a plurality of second electrodes provided spaced apart from the first electrode and respectively provided on the plurality of light-emitting cells.

## Description

### FIELD OF THE INVENTION

Example embodiments of the present disclosure relate to a light-emitting device, a display apparatus including the light-emitting device, and a method of manufacturing the display apparatus.

### BACKGROUND OF THE INVENTION

Light-emitting devices (LEDs) are known as a next-generation light source with advantages of long lifespan, low power consumption, a fast response speed, environment friendliness, and the like, compared to a light source according to related art, and are used in various products such as lighting apparatuses, backlights of display apparatuses, and the like. In particular, group-III nitride-based LEDs such as gallium nitride (GaN), aluminum gallium nitride (AIGaN), indium gallium nitride (InGaN), indium aluminum gallium nitride (InAIGaN), and the like serve a light-emitting device for emitting light.

### SUMMARY OF THE INVENTION

One or more example embodiments provide a light-emitting device including a plurality of light-emitting cells, and a manufacturing method thereof.

One or more example embodiments also provide a display apparatus including a light-emitting device including a plurality of light-emitting cells, and a manufacturing method thereof.

Additional aspects will be set forth in part in the description which follows and, in part, will be apparent from the description, or may be learned by practice of example embodiments of the disclosure.

According to an aspect of an example embodiment, there is provided a light-emitting device including a plurality of light-emitting cells, each of the plurality of light-emitting cells being configured to independently emit light, a common semiconductor layer provided on the plurality of light-emitting cells, a first electrode provided on the common semiconductor layer, and a plurality of second electrodes provided spaced apart from the first electrode and respectively provided on the plurality of light-emitting cells.

The plurality of light-emitting cells may be provided spaced apart from each other on a first surface of the common semiconductor layer.

A width of each of the plurality of light-emitting cells may be less than a width of the common semiconductor layer.

At least one of the plurality of light-emitting cells may include a first semiconductor layer, an active layer, and a second semiconductor layer, which are sequentially provided.

Each of the plurality of second electrodes may be provided on the second semiconductor layer.

A material of the first semiconductor layer may be the same as a material of the common semiconductor layer.

The first electrode may be provided on a first surface of the common semiconductor layer on which the plurality of light-emitting cells are provided.

The first electrode may extend toward an upper surface of at least one of the plurality of light-emitting cells along a side surface of at least one of the plurality of light-emitting cells.

The light-emitting device may further include a first insulating layer provided between the first electrode and the plurality of light-emitting cells.

The first insulating layer may be provided on each of the plurality of second electrodes.

The plurality of light-emitting cells may be symmetrical with respect to a center axis of the light-emitting device.

The plurality of second electrodes may be symmetrical with respect to a center axis of the light-emitting device.

The first electrode may be symmetrical with respect to a center axis of the light-emitting device.

At least one of the first electrode and the plurality of second electrodes may be transparent.

At least part of a space between the plurality of light-emitting cells may be filled with the first electrode.

The first electrode may be provided on a second surface of the common semiconductor layer that is different from a first surface of the common semiconductor layer on which the plurality of light-emitting cells are provided.

The light-emitting device may further include an insulating material filling at least part of a space between the plurality of light-emitting cells.

An outer circumferential surface of the common semiconductor layer may have at least one of a circular shape, an oval shape, and a polygonal shape.

An outer circumferential surface of a combination of the plurality of light-emitting cells may correspond to the outer circumferential surface of the common semiconductor layer.

According to another aspect of an example embodiment, there is provided a display apparatus including a display layer including a plurality of light-emitting devices, and a driving layer configured to drive the plurality of light-emitting devices, the driving layer including a plurality of transistors electrically connected to the plurality of light-emitting devices, respectively, wherein at least one of the plurality of light-emitting devices includes a plurality of light-emitting cells, each of the plurality of light-emitting cells being configured to independently emit light, and a common semiconductor layer provided on the plurality of light-emitting cells.

At least one of the plurality of light-emitting devices may include a first electrode provided on the common semiconductor layer and electrically connected to the driving layer, and a plurality of second electrodes provided spaced apart from the first electrode and respectively provided on the plurality of light-emitting cells.

The plurality of second electrodes may include a connection electrode that is electrically connected to the driving layer, and a non-connection electrode that is not electrically connected to the driving layer.

A light-emitting cell that is provided on the non-connection electrode may not be configured to emit light.

The display layer may further include a planarization layer provided on the plurality of light-emitting devices.

According to another aspect of an example embodiment, there is provided a light-emitting device including a plurality of light-emitting cells, each of the plurality of light-emitting cells being configured to independently emit light, a common semiconductor layer provided on a first surface of each of the plurality of light-emitting cells, a first electrode provided on the common semiconductor layer, an insulating layer provided between the first electrode and each of the plurality of light-emitting cells, and a plurality of second electrodes provided spaced apart from the first electrode and respectively provided on a second surface of each of the plurality of light-emitting cells that is opposite from the first surface.

### BRIEF DESCRIPTION OF THE DRAWINGS

The above and/or other aspects, features, and advantages of example embodiments of the disclosure will be more apparent from the following description taken in conjunction with the accompanying drawings, in which:
FIG. 1A is a cross-sectional view of a light-emitting device according to an example embodiment;
FIG. 1B is a plan view of the light-emitting device of FIG. 1A;
FIGS. 2A, 2B, 2C, and 2D are reference views for describing a method of manufacturing a light-emitting device, according to an example embodiment;
FIG. 3 is a cross-sectional view of a light-emitting device according to another example embodiment;
FIG. 4 is a cross-sectional view of a light-emitting device filled with an insulating material, according to an example embodiment;
FIG. 5 is a plan view of a light-emitting device according to another example embodiment;
FIG. 6 is a plan view of a light-emitting device including a plurality of sub-electrodes according to an example embodiment;
FIG. 7 is a plan view of a light-emitting device in which a first electrode is arranged at an edge area according to an example embodiment;
FIG. 8 is a plan view of a light-emitting device including three light-emitting cells according to an example embodiment;
FIG. 9 is a plan view of a light-emitting device including four light-emitting cells according to an example embodiment;
FIG. 10 is a plan view of a light-emitting device having different sections according to an example embodiment;
FIG. 11 is a plan view of an octagonal light-emitting device according to another example embodiment;
FIG. 12A is a cross-sectional view of a light-emitting device including a second insulating layer according to an example embodiment;
FIG. 12B is a cross-sectional view of a light-emitting device including a second insulating layer according to another example embodiment;
FIG. 13 is a cross-sectional view of a light-emitting device having a scattering pattern according to an example embodiment;
FIG. 14 is a cross-sectional view of a light-emitting device including electrodes arranged on both surfaces thereof according to an example embodiment;
FIG. 15 is a reference view for describing a defect rate of a light-emitting device according to an example embodiment;
FIGS. 16A, 16B, 16C, 16D, and 16E are reference views for describing a process of manufacturing a display apparatus by using a light-emitting device according to an example embodiment;
FIGS. 17A, 17B, 17C, 17D, and 17E are reference views for describing a process of manufacturing a display apparatus by using a light-emitting device according to another example embodiment; and
FIG. 18 is a view of a display apparatus including a light-emitting device according to another example embodiment.

### DETAILED DESCRIPTION

Reference will now be made in detail to example embodiments of which are illustrated in the accompanying drawings, wherein like reference numerals refer to like elements throughout. In this regard, the example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, example embodiments of the disclosure are described in detail with reference to the accompanying drawings. Although example embodiments are described, these are merely exemplary, and those skilled in the art to which the present disclosure pertains could make various modifications and changes from these descriptions. Throughout the drawings, like reference numerals denote like elements. Sizes of components in the drawings may be exaggerated for convenience of explanation.

When a constituent element is disposed "above" or "on" to another constituent element, the constituent element may be only directly on the other constituent element or above the other constituent elements in a non-contact manner.

Terms such as "first" and "second" are used herein merely to describe a variety of constituent elements, but the constituent elements are not limited by the terms. Such terms are used only for the purpose of distinguishing one constituent element from another constituent element.

An expression used in a singular form in the specification also includes the expression in its plural form unless clearly specified otherwise in context. When a part may "include" a certain constituent element, unless specified otherwise, it may not be construed to exclude another constituent element but may be construed to further include other constituent elements.

Furthermore, terms such as "to portion," "to unit," "to module," and "to block" stated in the specification may signify a unit to process at least one function or operation and the unit may be embodied by hardware, software, or a combination of hardware and software.

The use of the terms "a" and "an" and "the" and similar referents in the context of describing the disclosure (especially in the context of the following claims) are to be construed to cover both the singular and the plural.

Also, the steps of all methods described herein can be performed in any suitable order unless otherwise indicated herein or otherwise clearly contradicted by context. The disclosure is not limited to the described order of the steps. Furthermore, the connecting lines, or connectors shown in the various figures presented are intended to represent functional relationships and/or physical or logical couplings between the various elements. It should be noted that many alternative or additional functional relationships, physical connections or logical connections may be present in a practical device.

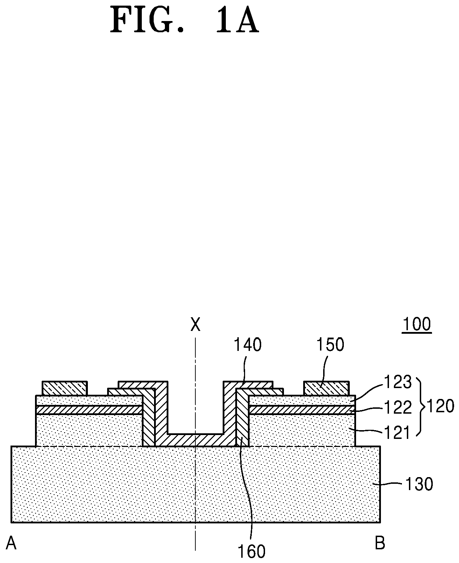

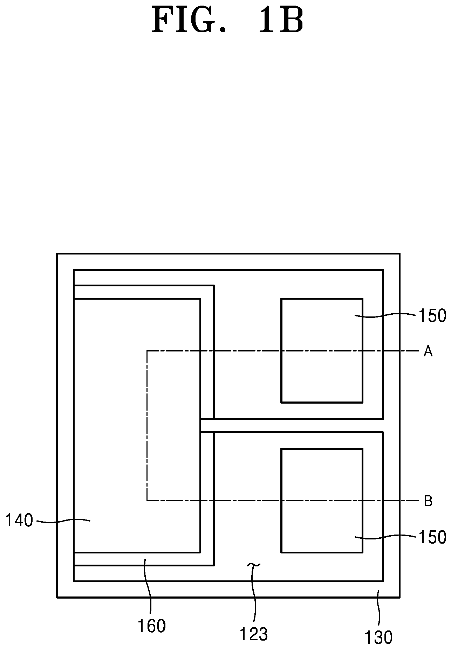

FIG. 1A is a cross-sectional view of a light-emitting device 100 according to an example embodiment. FIG. 1B is a plan view of the light-emitting device 100 of FIG. 1A.

As illustrated in FIG. 1A, the light-emitting device 100 may include a light-emitting diode based on an inorganic material, and the light-emitting device 100 may emit light of a particular wavelength according to a material included in the light-emitting device 100. The light-emitting device 100 according to an example embodiment may have a micro size. For example, the width of the light-emitting device 100 may be about 500 µm or less or about 100 µm or less.

The light-emitting device 100 may include a plurality of light-emitting cells 120, each being configured to independently emit light, a common semiconductor layer 130 in contact with the light-emitting cells 120, a first electrode 140 in contact with the common semiconductor layer 130, and a plurality of second electrodes 150 arranged to be spaced apart from the first electrode 140 and in contact with each of the light-emitting cells 120.

The light-emitting cells 120 may be arranged to be spaced apart from each other on a first surface of the common semiconductor layer 130. Although the drawings illustrate two light-emitting cells 120, embodiments are not limited thereto. The light-emitting device 100 may include two or more light-emitting cells 120. The light-emitting cells 120 may be arranged on the first surface of the common semiconductor layer 130 one dimensionally in one direction or two dimensionally in two directions.

The light-emitting cells 120 may each have the same shape. For example, a section in a widthwise direction, that is, a cross-section, of each of the light-emitting cells 120 may be circular, oval, and/or polygonal. A section of each of the light-emitting cells 120 in the thickness direction, that is, a side section, may be rectangular. The width of each of the light-emitting cells 120 may be less than the width of the common semiconductor layer 130. The light-emitting cells 120 described above may be arranged symmetrically with respect to the center axis X of the light-emitting device 100.

Each of the light-emitting cells 120 may include a first semiconductor layer 121, an active layer 122, and a second semiconductor layer 123, arranged in that order on the common semiconductor layer 130.

The first semiconductor layer 121 may include, for example, an n-type semiconductor. However, embodiments are not necessarily limited thereto, and in some cases, the first semiconductor layer 121 may include a p-type semiconductor. The first semiconductor layer 121 may include a group III-V-based n-type semiconductor, for example, n-GaN. The first semiconductor layer 121 may have a single layer or multilayer structure. For example, the first semiconductor layer 121 may include any one semiconductor material of InAIGaN, GaN, AIGaN, InGaN, aluminum nitride (AIN), indium nitride (InN), and include a semiconductor layer doped with a conductive dopant such as silicon (Si), germanium (Ge), tin (Sn), and the like.

The active layer 122 may be arranged on an upper surface of the first semiconductor layer 121. The active layer 122 may generate light as electrons and holes combine with each other, and have a multi-quantum well (MQW) structure or a single-quantum well (SQW) structure. The active layer 122 may include a group III-V-based semiconductor, for example, InGaN, GaN, AIGaN, aluminum indium gallium nitride (AlInGaN), and the like. A clad layer doped with a conductive dopant may be formed above and below the active layer 122. In an example, the clad layer may include an AIGaN layer or an InAIGaN layer.

The second semiconductor layer 123 may be provided on an upper surface of the active layer 122 opposite to the first semiconductor layer 121, and may include a semiconductor layer of a type different from the first semiconductor layer 121. For example, the second semiconductor layer 123 may include a p-type semiconductor layer. The second semiconductor layer 123 may include, for example, InAIGaN, GaN, AIGaN, and/or InGaN, and may be a semiconductor layer doped with a conductive dopant such as magnesium (Mg) and the like.

The common semiconductor layer 130 may be in contact with the light-emitting cells 120. The material of the common semiconductor layer 130 may be the same as the material of the first semiconductor layer 121. For example, the common semiconductor layer 130 may include an n-type semiconductor. For example, the common semiconductor layer 130 may include a group III-V-based n-type semiconductor, for example, n-GaN. The common semiconductor layer 130 may have a single layer or multilayer structure. For example, the common semiconductor layer 130 may include any one semiconductor material of InAIGaN, GaN, AIGaN, InGaN, AIN, and InN, and include a semiconductor layer doped with a conductive dopant such as Si, Ge, Sn, and the like.

The section in a widthwise direction, that is, a cross-section, of the common semiconductor layer 130 may be circular, oval, polygonal, and the like. The section in a thickness direction of the common semiconductor layer 130 may have a rectangular shape. For example, the side section of the common semiconductor layer 130 may be rectangular.

The first electrode 140 may be in contact with the common semiconductor layer 130. The first electrode 140 may be in contact with the common semiconductor layer 130 on the first surface of the common semiconductor layer 130, where the light-emitting cells 120 are arranged. The first electrode 140 may extend toward the upper surfaces of the light-emitting cells 120 along the side surfaces of the light-emitting cells 120. For example, the first electrode 140 may be in contact with the common semiconductor layer 130 in a middle area of the common semiconductor layer 130 between adjacent light-emitting cells 120, and may be arranged to extend toward the upper surfaces of the light-emitting cells 120 along the side surfaces of the light-emitting cells 120 that are adjacent to each other.

The first electrode 140 may be arranged symmetrically with respect to the center axis X of the light-emitting device 100. In FIG. 1B, the first electrode 140 may be arranged line-symmetrically to the center axis X of the light-emitting device 100.

The first electrode 140 may include a conductive material. For example, the first electrode 140 may include a transparent conductive material and may be a transparent electrode. The first electrode 140 may include a metal such as silver (Ag), Mg, aluminum (Al), platinum (Pt), palladium (Pd), gold (Au), nickel (Ni), neodymium (Nd), iridium (Ir), chromium (Cr), and an alloy thereof, a conductive oxide such as indium tin oxide (ITO), indium zinc oxide (IZO), zinc oxide (ZnO), indium tin zinc oxide (ITZO), a conductive polymer such as poly(3,4-ethylenedioxythiophene) polystyrene sulfonate (PEDOT), and the like.

The light-emitting device 100 may include the second electrodes 150 respectively in contact with the light-emitting cells 120. The second electrodes 150 may be in contact with the second semiconductor layers 123 of the light-emitting cells 120, respectively. The second electrodes 150 may be arranged symmetrically with respect to the center axis X of the light-emitting device 100. In the drawings, the second electrodes 150 are arranged line-symmetrically to the center axis X of the light-emitting device 100. The second electrodes 150, like the first electrode 140, may include a transparent conductive material.

The light-emitting device 100 may further include a first insulating layer 160 surrounding and provided adjacent to the side surfaces of the light-emitting cells 120. A partial area of the first insulating layer 160 may extend toward the upper surfaces of the light-emitting cells 120. Accordingly, the first insulating layer 160 may prevent the first electrode 140 from contacting the active layer 122 and the second semiconductor layer 123 of each of the light-emitting cells 120. In the drawings, the first insulating layer 160 is illustrated to be arranged to be spaced apart from the second electrodes 150. However, embodiments are not limited thereto. The first insulating layer 160, which is in contact with the second electrodes 150, may prevent the second semiconductor layer 123 from being exposed to the outside.

Each of the light-emitting cells 120 may independently emit light in response to electrical signals applied to the first electrode 140 and the second electrodes 150 respectively corresponding to the light-emitting cells 120. Accordingly, even when any one of the light-emitting cells 120 is defective, the light-emitting cells 120 may normally emit light, and thus, the light-emitting device 100 may normally operate as a whole. Accordingly, a defect rate of the light-emitting device 100 may decrease in proportion to the number of light-emitting cells 120.

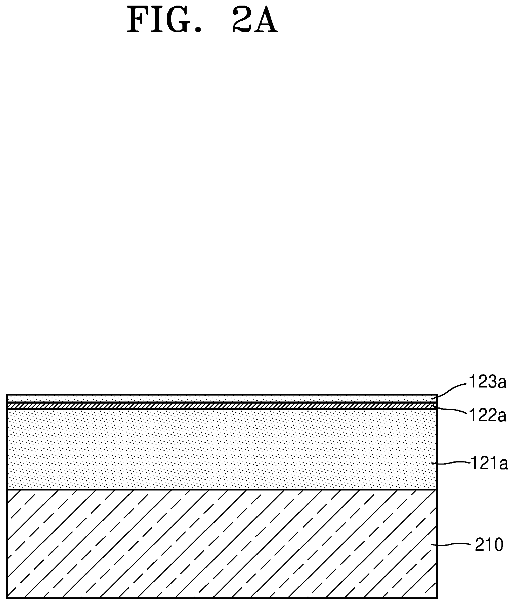

FIGS. 2A to 2D are reference views for describing a method of manufacturing the light-emitting device 100 according to an example embodiment.

As illustrated in FIG. 2A, a first semiconductor material layer 121a, an active material layer 122a, and a second semiconductor material layer 123a may be sequentially formed on and above a first substrate 210. The first substrate 210 may be a substrate for growing a semiconductor material. The first substrate 210 may include various materials used for a general semiconductor process. For example, a silicon substrate, a sapphire substrate, and the like may be used as the first substrate 210.

The first semiconductor material layer 121a, the active material layer 122a, and the second semiconductor material layer 123a may be formed by a method such as metal organic chemical vapor deposition (MOCVD), chemical vapor deposition (CVD), plasma-enhanced CVD (PECVD), molecular beam epitaxy (MBE), hydride vapor phase epitaxy (HVPE), and the like.

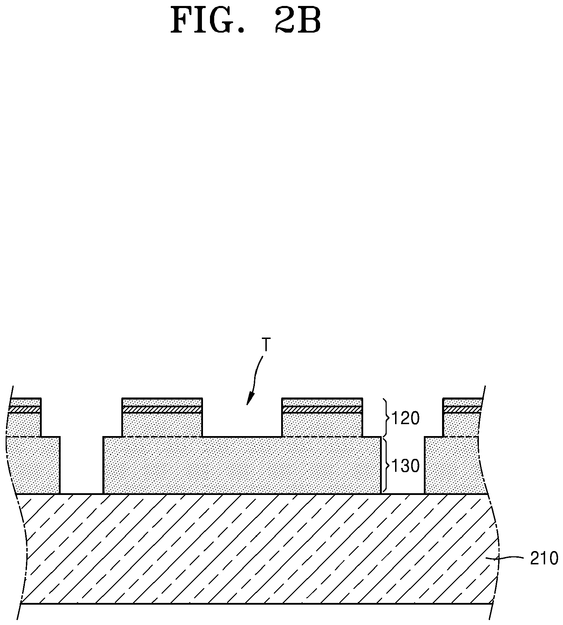

As illustrated in FIG. 2B, the common semiconductor layer 130 and the light-emitting cells 120 may be formed by patterning the first semiconductor material layer 121a, the active material layer 122a, and the second semiconductor material layer 123a. The common semiconductor layer 130 and the light-emitting cells 120 may be referred to as a body. A trench T may be formed in the first semiconductor material layer 121a, the active material layer 122a, and the second semiconductor material layer 123a to expose the first semiconductor material layer 121a by penetrating the second semiconductor material layer 123a and the active material layer 122a. A partial area of the first semiconductor material layer 121a may become the common semiconductor layer 130, and the other area of the first semiconductor material layer 121a may become the first semiconductor layer 121 of the light-emitting cells 120. However, embodiments are not limited thereto. The first semiconductor material layer 121a may entirely become the common semiconductor layer 130, and the light-emitting cells 120 may not include the first semiconductor layer 121. For example, the light-emitting cells 120 may include only the active layer 122 and the second semiconductor layer 123.

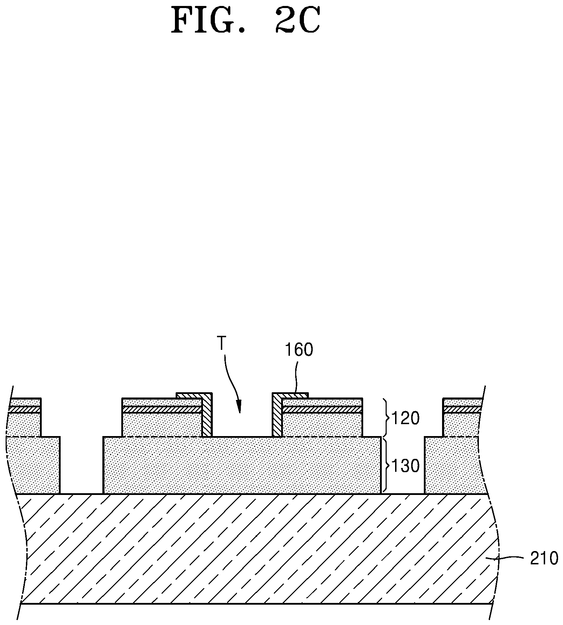

As illustrated in FIG. 2C, the first insulating layer 160 may be formed in the trench T between the light-emitting cells 120. The first insulating layer 160 may extend toward the upper surfaces of the light-emitting cells 120 by surrounding and being provided adjacent to the side surfaces of the light-emitting cells 120. In addition, the first insulating layer 160 may extend toward the common semiconductor layer 130 while exposing a partial area of the common semiconductor layer 130.

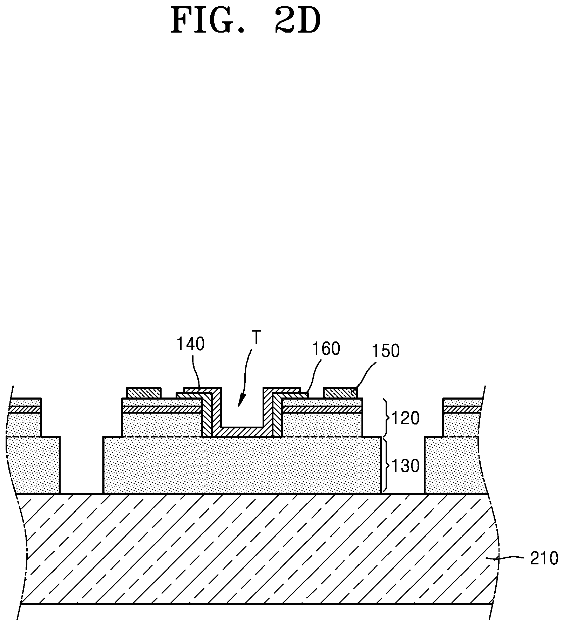

As illustrated in FIG. 2D, the first electrode 140 in contact with the common semiconductor layer 130 and the second electrodes 150 in contact with the second semiconductor layer 123 may be formed. The first electrode 140 may be in contact with the common semiconductor layer 130 at a bottom surface of the trench T and extend toward the first insulating layer 160 on the upper surfaces of the light-emitting cells 120 by passing the side surfaces of the light-emitting cells 120. The first electrode 140 may be prevented from contacting the active layer 122 and the second semiconductor layer 123 of each of the light-emitting cells 120, by the first insulating layer 160. The second electrodes 150 may be arranged on the upper surfaces of the second semiconductor layers 123 of the light-emitting cells 120, apart from the first electrode 140.

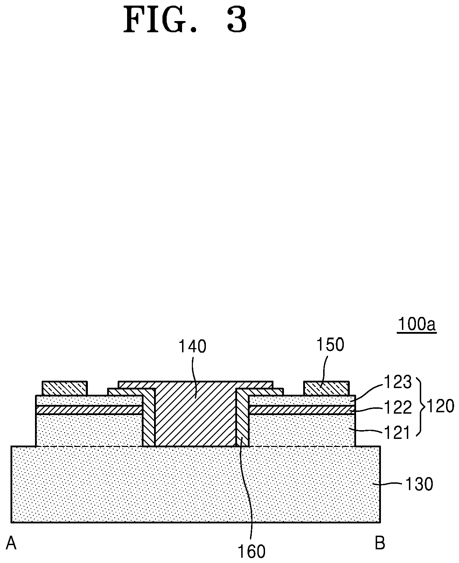

FIG. 3 is a cross-sectional view of a light-emitting device 100a according to another example embodiment. When comparing FIG. 1 with FIG. 3, the first electrode 140 of the light-emitting device 100a of FIG. 3 may fill at least part of space between the adjacent light-emitting cells 120. When the space between the light-emitting cells 120 of the light-emitting device 100 is empty, mechanical strength of the light-emitting device 100 may be decreased. As at least part of the space between the light-emitting cells 120 is filled with the first electrode 140, the mechanical strength of the light-emitting device 100 may be prevented from being decreased.

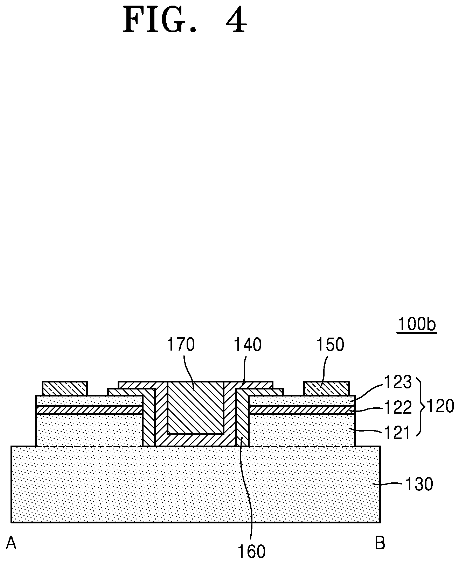

FIG. 4 is a cross-sectional view of a light-emitting device 100b filled with an insulating material according to an example embodiment. The light-emitting device 100b of FIG. 4 may further include an insulating material 170 that fills at least part of the space between the adjacent light-emitting cells 120. When the space between the light-emitting cells 120 is filled with the same material as the first electrode 140, the thickness of the first electrode 140 increases, and thus the transparency of the first electrode 140 arranged in the space between the light-emitting cells 120 may be reduced. Then, as light generated by the active layer 122 is reflected by the first electrode 140, light-emitting efficiency may be reduced. Accordingly, as at least part of the space between the light-emitting cells 120 is filled with a transparent insulating material 170, light-emitting efficiency may be prevented from being reduced.

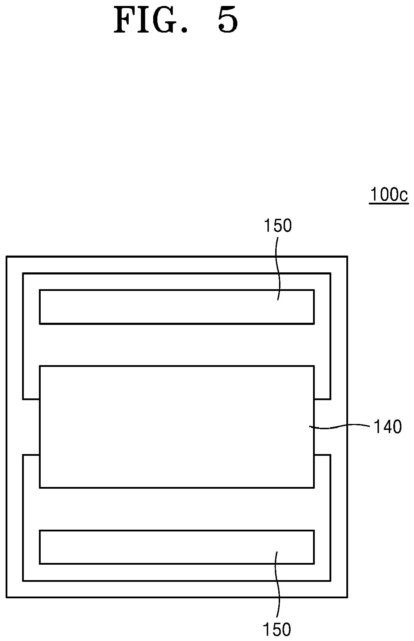

FIG. 5 is a plan view of a light-emitting device 100c according to another example embodiment. As illustrated in FIG. 5, the first electrode 140 may be arranged in a middle area of the light-emitting device 100c, and the second electrodes 150 may be arranged at edge areas of the light-emitting device 100c. The first electrode 140 may be arranged to be in contact with the common semiconductor layer 130 between the light-emitting cells 120 and extend toward the upper surfaces of the light-emitting cells 120 along the side surfaces of the light-emitting cells 120. The second electrodes 150 may be arranged on the upper surface of each of the light-emitting cells 120. The first and second electrodes 140 and 150 may be arranged symmetrically with respect to the center axis of the light-emitting device 100.

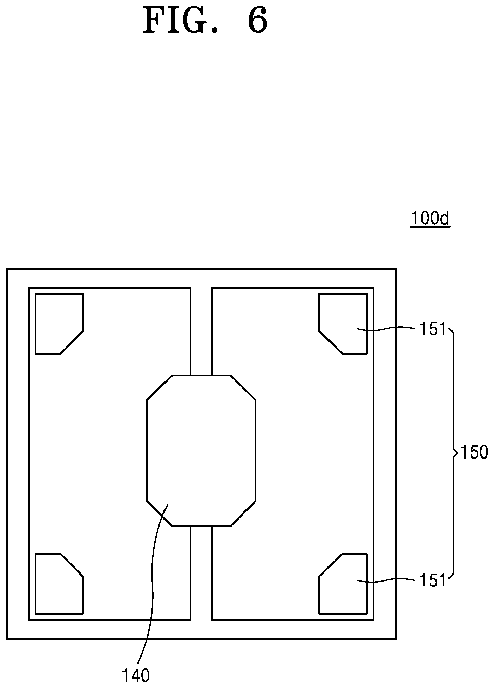

FIG. 6 is a plan view of a light-emitting device 100d including a plurality of sub-electrodes according to an example embodiment. When comparing FIG. 5 with FIG. 6, the second electrodes 150 included in the light-emitting device 100d of FIG. 6 may include a plurality of sub-electrodes 151. For example, each of the second electrodes 150 may include a plurality of sub-electrodes 151. As the second electrodes 150 are implemented as the plurality of sub-electrodes 151, a distance between the first electrode 140 and the second electrode 150 may be maintained at a certain distance or more. The sub-electrodes 151 may also be line symmetrical or rotationally symmetrical with respect to the center axis of the light-emitting device 100d.

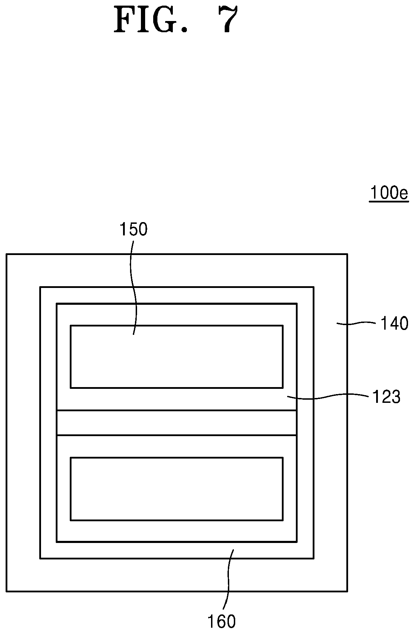

FIG. 7 is a plan view of a light-emitting device 100e in which a first electrode is arranged at an edge area according to an example embodiment. As illustrated in FIG. 7, the first electrode 140 may be arranged at an edge area of the light-emitting device 100e, and the second electrodes 150 may be arranged in a middle area of the light-emitting device 100e. The first electrode 140 may be arranged to be in contact with the common semiconductor layer 130 at the edges of the light-emitting cells 120 and to extend toward the upper surfaces of the light-emitting cells 120 along the side surfaces of the light-emitting cells 120. The second electrodes 150 may be arranged in the middle area of the light-emitting device 100e on the upper surface of each of the light-emitting cells 120. The first and second electrodes 140 and 150 may be arranged rotationally symmetrical or line symmetrical with respect to the center axis of the light-emitting device 100e.

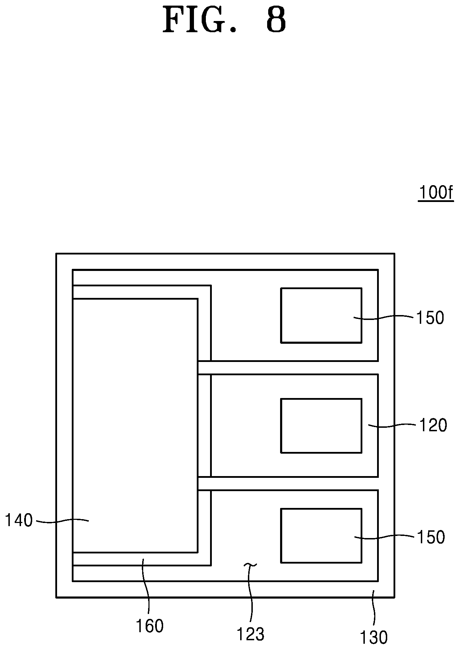

FIG. 8 is a plan view of a light-emitting device 100f including three light-emitting cells according to an example embodiment. When comparing FIG. 1 with FIG. 8, the light-emitting device 100f of FIG. 8 may include three light-emitting cells 120. The first electrode 140 may be in contact with the common semiconductor layer 130 and extend toward the upper surfaces of the three light-emitting cells 120 along three side surfaces of the light-emitting cells 120. Three second electrodes 150 may be respectively arranged on the upper surfaces of the light-emitting cells 120.

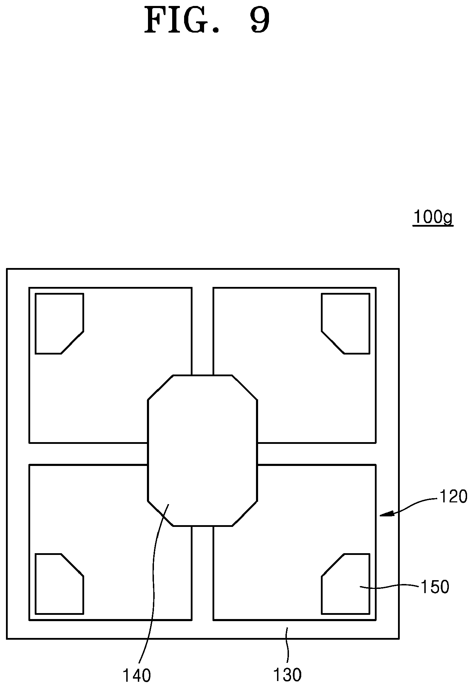

FIG. 9 is a plan view of a light-emitting device 100g including four light-emitting cells 120 according to an example embodiment. The light-emitting device 100g of FIG. 9 may include four light-emitting cells 120. The first electrode 140 may be arranged at the center area of the light-emitting device 100g, and the four second electrodes 150 may be arranged at edge areas of the light-emitting device 100g. The first and second electrodes 140 and 150 may be arranged rotationally symmetrical or line symmetrical with respect to the center axis of the light-emitting device 100g.

As the number of light-emitting cells increase, the defect rate of the light-emitting device may be reduced. The section of a light-emitting device and the section of a light-emitting cell, which are described above, correspond to each other. For example, when the section of a light-emitting device is polygonal, the section of a light-emitting cell is polygonal as well. However, embodiments are not limited thereto. The section of a light-emitting device may be different from the section of a light-emitting cell.

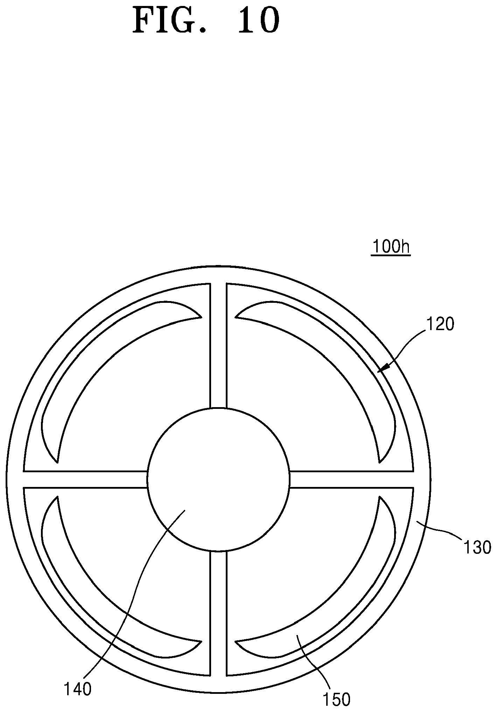

FIG. 10 is a plan view of a light-emitting device 100h having different sections according to an example embodiment. As illustrated in FIG. 10, the section of the light-emitting device 100h may be circular. For example, the section of an outer circumferential surface of the common semiconductor layer 130 may be circular, and the section of an outer circumferential surface of a combination of the light-emitting cells 120 may be circular. However, the section of an outer circumferential surface of each of the light-emitting cells 120 may be a fan shape. The first electrode 140 may be arranged at the center area of the light-emitting device 100h, and the second electrodes 150 may be arranged at edge areas of the light-emitting device 100h, but embodiments are not limited thereto. For example, the first and second electrodes 140 and 150 may be arranged reversely. The first and second electrodes 140 and 150 may be symmetrical with respect to the center axis of the light-emitting device 100h. For example, the first and second electrodes 140 and 150 may be rotationally symmetrical or line symmetrical with respect to the center axis of the light-emitting device 100h.

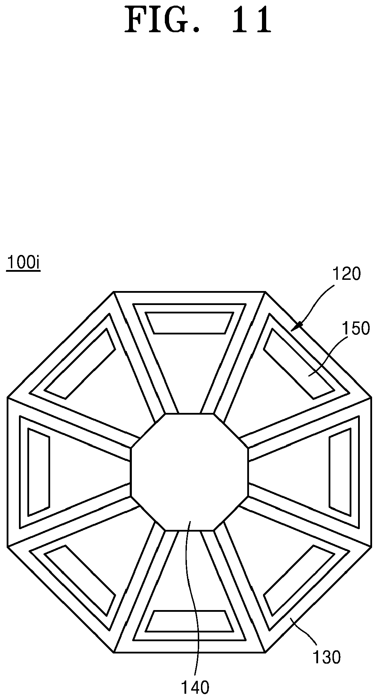

FIG. 11 is a plan view of a light-emitting device 100i having a section that is octagonal according to another example embodiment. As illustrated in FIG. 11, the section of the light-emitting device 100i may be octagonal. For example, the section of an outer circumferential surface of the common semiconductor layer 130 may be octagonal, and the section of an outer circumferential surface of a combination of the light-emitting cells 120 may be octagonal. However, embodiments are not limited thereto. For example, the section of an outer circumferential surface of each of the light-emitting cells 120 may be triangular. The first electrode 140 may be arranged at the center area of the light-emitting device 100i, and the second electrodes 150 may be arranged at edge areas of the light-emitting device 100i, but embodiments are not limited thereto, and the first and second electrodes 140 and 150 may be arranged reversely.

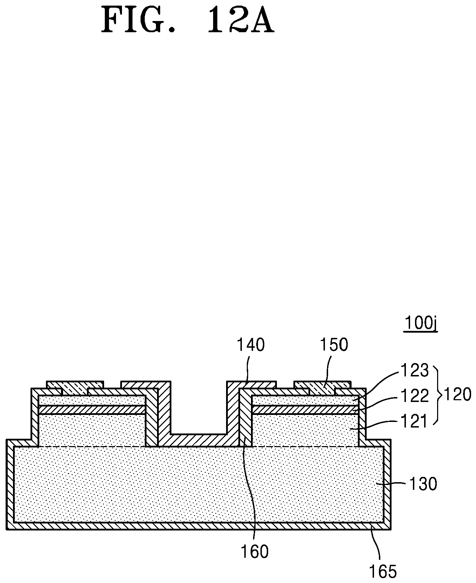

FIG. 12A is a cross-sectional view of a light-emitting device 100j including a second insulating layer 165 according to an example embodiment. As illustrated in FIG. 12A, a second insulating layer 165 may be arranged at a side surface of the light-emitting device 100j. The second insulating layer 165 may be in contact with the second electrodes 150 respectively on the upper surfaces of the light-emitting cells 120. The second insulating layer 165 along the side surfaces of the light-emitting cells 120 and the common semiconductor layer 130 may surround and be provided on a lower surface of the common semiconductor layer 130. The first insulating layer 160 may be in contact with the second electrodes 150 by extending toward the upper surfaces of the light-emitting cells 120 while surrounding and being provided adjacent to the side surfaces of the light-emitting cells 120. First and second insulating layers 160 and 165 may serve as a protection film for protecting the light-emitting device 100j from the outside, in addition to a film performing an electrical insulating function between the light-emitting cells 120 and the first and second electrodes 140 and 150.

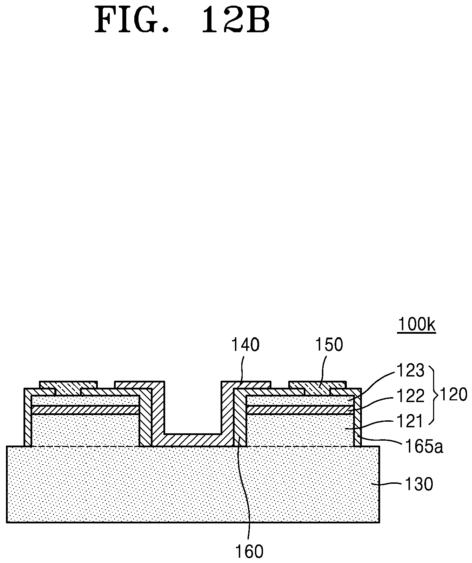

FIG. 12B is a cross-sectional view of a light-emitting device 100k including a second insulating layer 165a according to another example embodiment. As illustrated in FIG. 12B, the second insulating layer 165a may be arranged at a side surface of the light-emitting device 100k. The second insulating layer 165a may be in contact with the second electrodes 150 respectively on the upper surfaces of the light-emitting cells 120. The second insulating layer 165a may surround the side surfaces of the light-emitting cells 120, and may expose at least partial area of the common semiconductor layer 130.

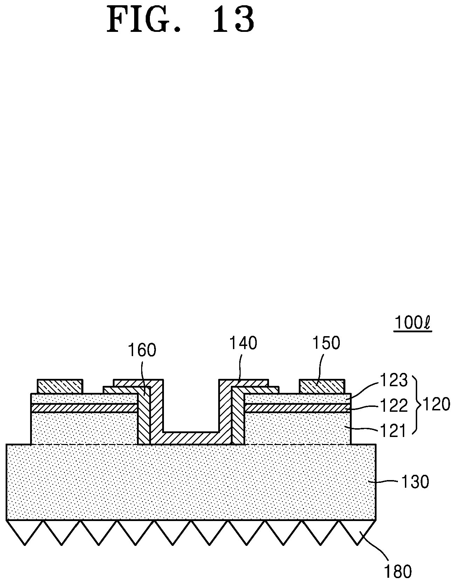

FIG. 13 is a cross-sectional view of a light-emitting device 1001 having a scattering pattern according to an example embodiment. As illustrated in FIG. 13, a scattering pattern 180 may be further arranged on the common semiconductor layer 130 of the light-emitting device 1001. The scattering pattern 180 may be arranged on the lower surface of the common semiconductor layer 130 to protrude outward. However, embodiments are not limited thereto. The scattering pattern 180 may be arranged to be embedded in the common semiconductor layer 130. The scattering pattern 180 may include a low dielectric material, for example, a material having a dielectric constant of 4 or less.

The electrodes of a light-emitting device are described above as being arranged to face one direction. As the electrodes are arranged to face one direction, the light-emitting device 100 may be more easily transferred to another substrate. However, embodiments are not limited thereto. The first and second electrodes 140 and 150 may be arranged on different surfaces of a light-emitting device, and the formation timings of the first and second electrodes 140 and 150 may be different from each other. For example, after the second electrodes 150 are formed on a body consisting of the common semiconductor layer 130 and the light-emitting cells 120, the body where the second electrodes 150 is formed may be transferred to another substrate. Then, the first electrode 140 may be formed on the body.

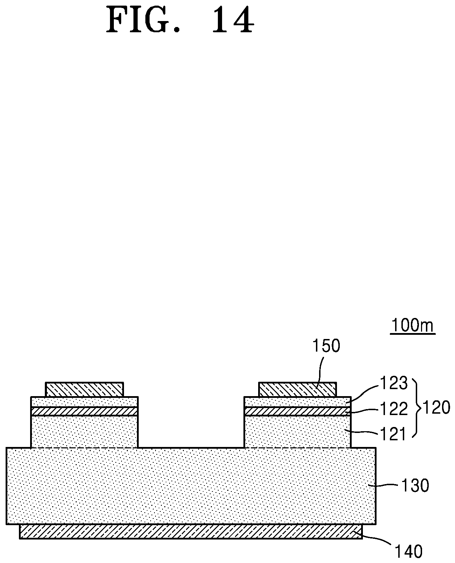

FIG. 14 is a view of a light-emitting device 100m including electrodes arranged on both surfaces thereof according to an example embodiment. As illustrated in FIG. 14, the first electrode 140 may be arranged on the lower surface of the common semiconductor layer 130, that is, the lower surface of the light-emitting device 1001, and the second electrodes 150 may be arranged on the upper surfaces of the light-emitting cells 120, that is, the upper surface of the light-emitting device 100m opposite to the first electrode 140. As the first and second electrodes 140 and 150 are arranged on different surfaces of the light-emitting device 100m, an electrode of a large size may be secured.

When a light-emitting device is manufactured in a micro size, defects may be often generated in a growth process of a semiconductor material. A defective light-emitting device that does not emit light due to a defect and the like may be manufactured. Repairing a light-emitting device 100 that is defective may cause difficulty in processing or lower a process yield.

As each light-emitting cell of a light-emitting device according to an example embodiment independently receives an electrical signal through a corresponding second electrode, each light-emitting cell may independently emit light. Accordingly, even when one light-emitting cell fails to emit light due to a defect and the like, the other light-emitting cells may emit light, and thus a defect rate of a light-emitting device may be reduced. For example, the defect rate of a light-emitting device having two light-emitting cells may be reduced to 1/2 of the defect rate of a light-emitting device having one light-emitting cell, and the defect rate of a light-emitting device having four light-emitting cells may be reduced to 1/4 of the defect rate of a light-emitting device including one light-emitting cell.

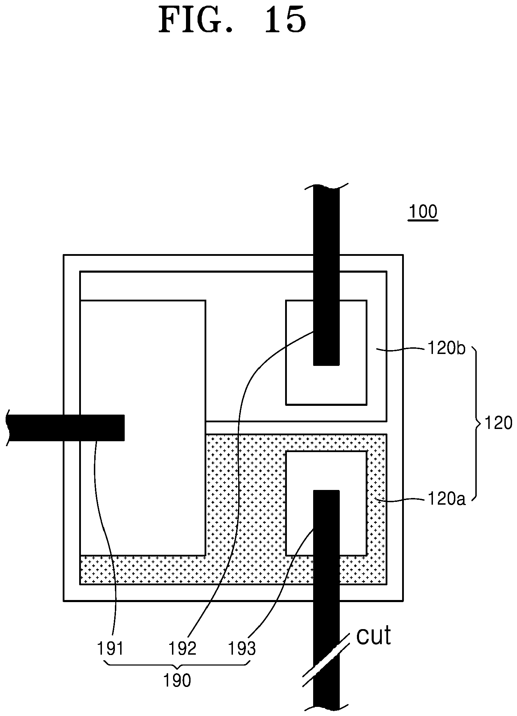

FIG. 15 is a reference view for describing a defect rate of the light-emitting device 100 according to an example embodiment. As illustrated in FIG. 15, an electrode pattern 190 for electrically connecting a driving layer may be formed on the light-emitting device 100. The electrode pattern 190 may include a first wiring 191 connected to the first electrode 140 and a plurality of second wirings 192 and 193 connected to the second electrodes 150. Electrical signals may be applied to the light-emitting device 100 through the first and second wirings 191, 192, and 193, and among the light-emitting cells 120, a first light-emitting cell 120a may not emit light. However, as a second light-emitting cell 120b emits light, the light-emitting device 100 may still emit light. A current flow may concentrate on the second light-emitting cell 120b by cutting the third wiring 193 connected to the first light-emitting cell 120a, and thus a decrease in the luminance of the light-emitting device 100 due to the first light-emitting cell 120a that is defective may be reduced. The second electrode of the first light-emitting cell 120a connected to the third wiring 193 that is cut may be referred to as a non-connection electrode, and the second electrode of the second light-emitting cell 120b connected to the second wiring 192 that is not cut may be referred to as a connection electrode.

The light-emitting devices 100, 100a, 100b, 100c, 100d, 100e, 100f, 100g, 100h, 100i, 100j, 100k,100l and 100m described above may be used as light-emitting sources of various apparatuses. In an example, light-emitting devices 100, 100a, 100b, 100c, 100d, 100e, 100f, 100g, 100h, 100i, 100j, 100k, 1001, and 100m may be applied to lighting apparatuses or self-luminescent display apparatuses. For example, the light-emitting devices 100, 100a, 100b, 100c, 100d, 100e, 100f, 100g, 100h, 100i, 100j, 100k, 100l, and 100m may be one constituent element of a display apparatus by being transferred by a fluidic self-assembly method, a pick and place method, and the like.

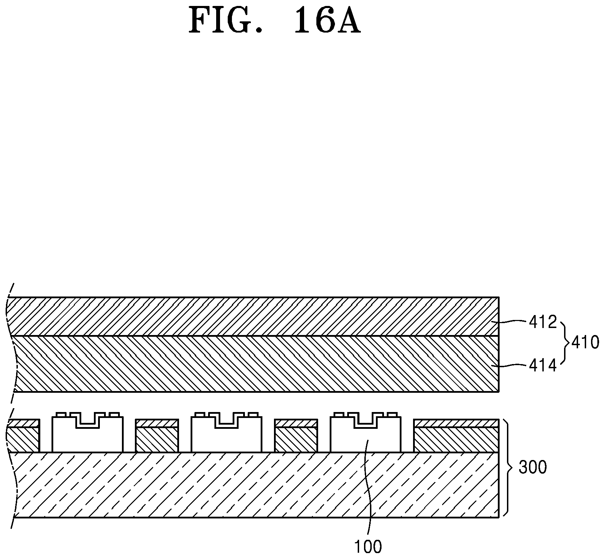

FIGS. 16A to 16E are reference views for describing a process of manufacturing a display apparatus by using the light-emitting device 100 according to an example embodiment.

Referring to FIG. 16A, a target substrate 410 may be aligned on a transfer substrate 300 to which the light-emitting device 100 is transferred. The light-emitting device 100 may be transferred to the transfer substrate 300 by a fluidic self-assembly method, a pick and place method, and the like. The target substrate 410 may include a substrate 412 and a driving layer 414. The substrate 412 may include an insulating material such as glass, organic polymer, crystal, and the like. Furthermore, the substrate 412 may include a flexible material that is bendable or foldable, and may have a single layer structure or a multilayer structure. The driving layer 414 may include a transistor, an electrode pattern, and the like for driving the light-emitting device 100. The electrodes of the light-emitting device 100 may be arranged to face an electrode pattern formed on the target substrate 410.

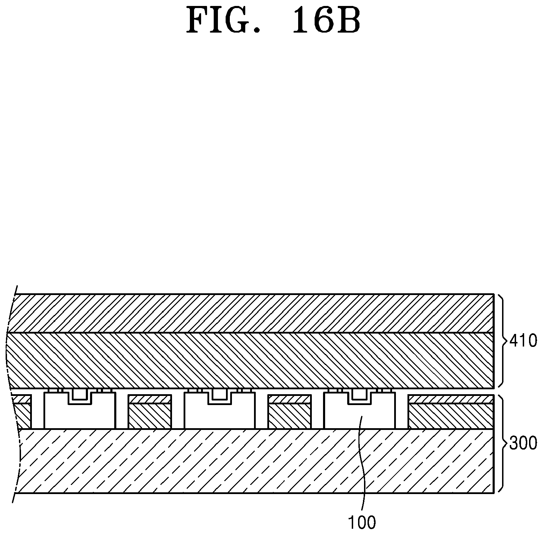

As illustrated in FIG. 16B, the light-emitting device 100 may be transferred to the target substrate 410. For example, the light-emitting device 100 may be transferred to the target substrate 410 by a bonding method. After the transfer substrate 300 and the target substrate 410 are aligned with each other, the light-emitting device 100 may be bonded to the target substrate 410 by using thermocompression, ultrasound, light (laser or UV), and the like. For example, when thermocompression is applied between the electrodes of the light-emitting device 100 and the electrode pattern of the target substrate 410, the electrodes of the light-emitting device 100 may be compressed in proportion to pressure and temperature to be bonded to the electrode pattern of the target substrate 410.

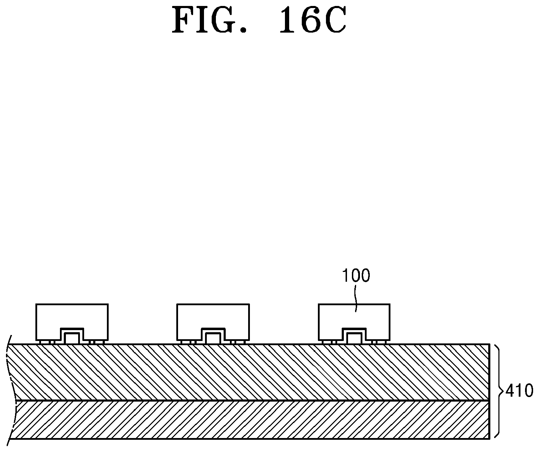

After the light-emitting device 100 is transferred to the target substrate 410, the transfer substrate 300 is removed. As illustrated in FIG. 16C, the target substrate 410 may be reversed where the light-emitting device 100 faces upwards.

When the transfer substrate 300 is a target substrate including a driving layer, without additional transfer, the light-emitting device 100 may be bonded to the transfer substrate 300.

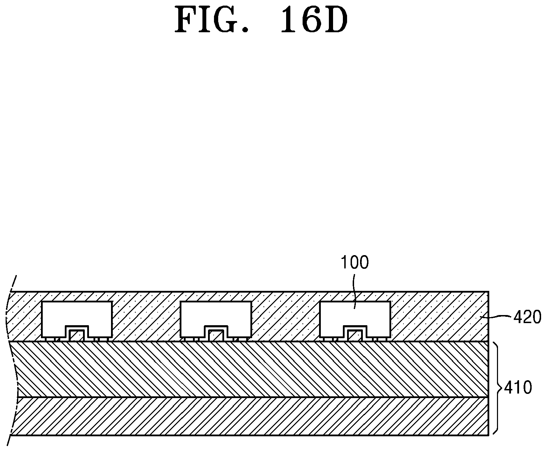

As illustrated in FIG. 16D, a planarization layer 420 may be formed on the light-emitting device 100. The planarization layer 420 may have a planarized upper surface while covering the light-emitting device 100. The planarization layer 420 may alleviate a step generated by constituent elements arranged below the planarization layer 420, and prevent infiltration of oxygen, moisture, and the like into the light-emitting device 100. The planarization layer 420 may include an insulating material. The planarization layer 420 may include an organic insulating film (an acryl or silicon-based polymer) or an inorganic insulating film (silicon oxide (SiO2), silicon nitride (SiN), aluminum oxide (Al2O3) or titanium oxide (TiO2)), and the like, but embodiments are not limited thereto. The planarization layer 420 may have a multilayer structure including a plurality of insulating materials having different dielectric constants.

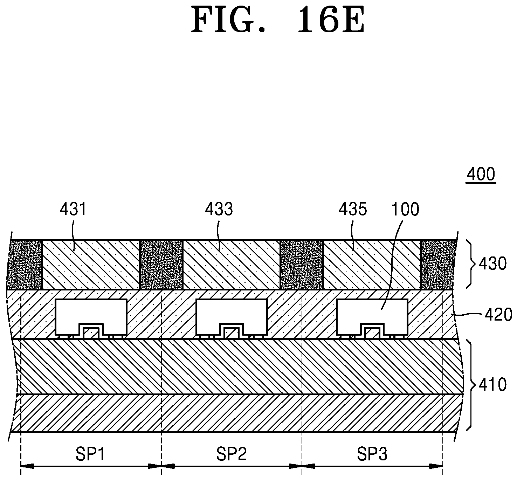

As illustrated in FIG. 16E, a color conversion layer 430 may be formed on the planarization layer 420. When the light-emitting device 100 emits light of the same wavelength, the color conversion layer 430 may include first to third color conversion patterns 431, 433, and 435 for converting the light generated by the light-emitting device 100 into light of a certain wavelength. Each of the first to third color conversion patterns 431, 433, and 435 may correspond to each subpixel. For example, the first color conversion pattern 431 may correspond to a first subpixel SP1, the second color conversion pattern 433 may correspond to a second subpixel SP2, and the third color conversion pattern 435 may correspond to a third subpixel SP3. The color conversion layer 430 may be formed by a photolithography method.

In the drawings, one light-emitting device 100 is illustrated to be arranged in one subpixel. However, embodiments are not limited thereto. One subpixel may include two or more light-emitting devices 100. As each of the light-emitting devices 100 includes the light-emitting cells 120, even when one or more of the light-emitting cells 120 do not emit light, the other of the light-emitting cells 120 may emit light, and thus, a defect rate of the subpixels may be reduced, and repair of subpixels is unnecessary.

Although FIG. 16E illustrates that the light-emitting device 100 emits light of the same wavelength, embodiments are not limited thereto. When each of the light-emitting devices 100 performs a subpixel function by emitting different light, for example, red light, blue light, and green light, the display apparatus may not need to include the color conversion layer. Although the method of manufacturing the display apparatus uses the light-emitting device 100 of FIG. 1, embodiments are not limited thereto. The display apparatus may be manufactured by using the light-emitting devices 100a, 100b, 100c, 100d, 100e, 100f, 100g, 100h, 100i, 100j, 100k, 1001, and 100m of FIGS. 3 to 14.

In the display apparatus 400 manufactured through FIGS. 16A to 16E, the electrodes of the light-emitting device 100 are arranged to face the target substrate 410. However, embodiments are not limited thereto. Even when the electrodes are arranged to face in a direction opposite to the target substrate 410, the display apparatus may be manufactured by using the light-emitting device 100.

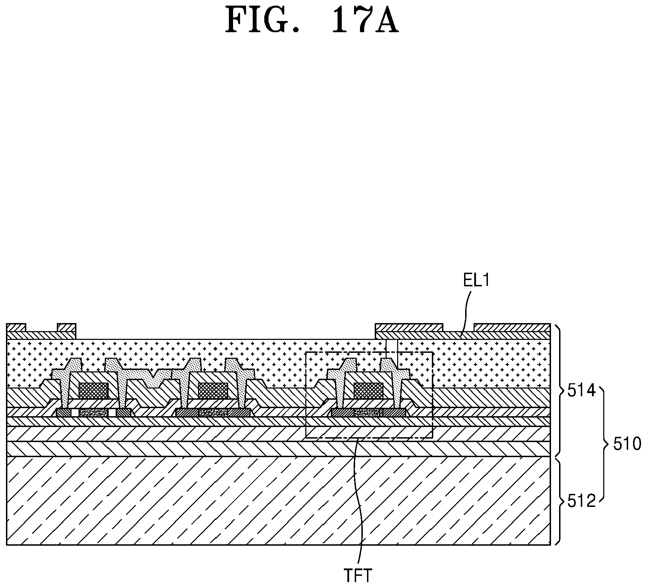

FIGS. 17A to 17E are reference views for describing a process of manufacturing a display apparatus 500 by using the light-emitting device 100 according to another example embodiment.

As illustrated in FIG. 17A, a driving layer 514 may be formed on a substrate 512. The driving layer 514 may include a TFT, a first electrode pattern EL1, a capacitor, and the like.

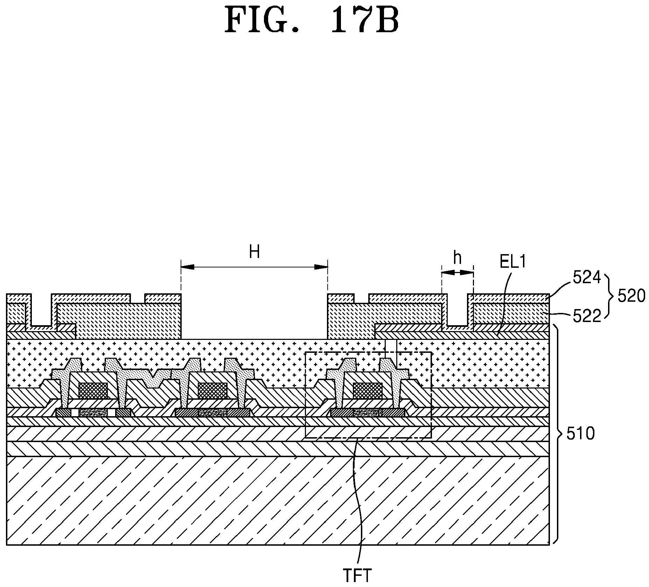

As illustrated in FIG. 17B, a flexible partition wall 520 having a hole H may be formed on the driving layer 514. The flexible partition wall 520 may include a polymer layer 522 and a metal layer 524. The metal layer 524 may be electrically connected to the first electrode pattern EL1 of the driving layer 514 via a hole TH formed in the polymer layer 522. The substrate 512, the driving layer 514, and the flexible partition wall 520 may form a transfer substrate.

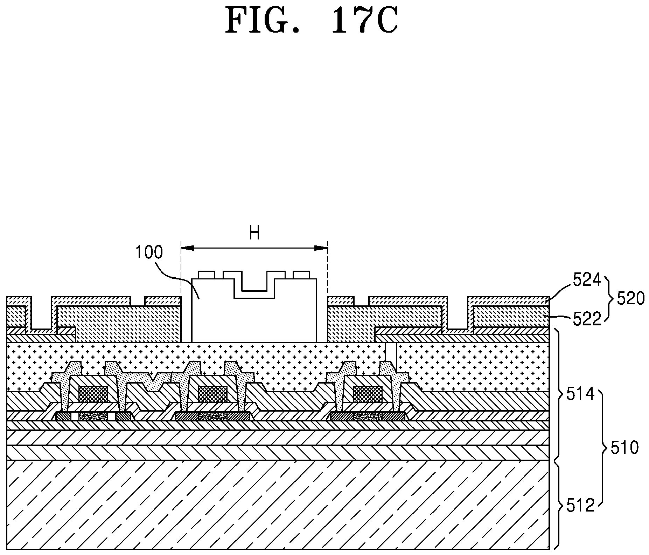

As illustrated in FIG. 17C, the light-emitting device 100 may be transferred to the transfer substrate in the hole H. The light-emitting device 100 is the same as illustrated in FIG. 1A, but embodiments are not limited thereto. The light-emitting devices 100a, 100b, 100c, 100d, 100e, 100f, 100g, 100h, 100i, 100j, 100k and 100l of FIGS. 3 to 14 of FIGS. 2 to 13 may be transferred to the transfer substrate. The light-emitting device 100 may be transferred by a fluidic self-assembly method or a pick and place method.

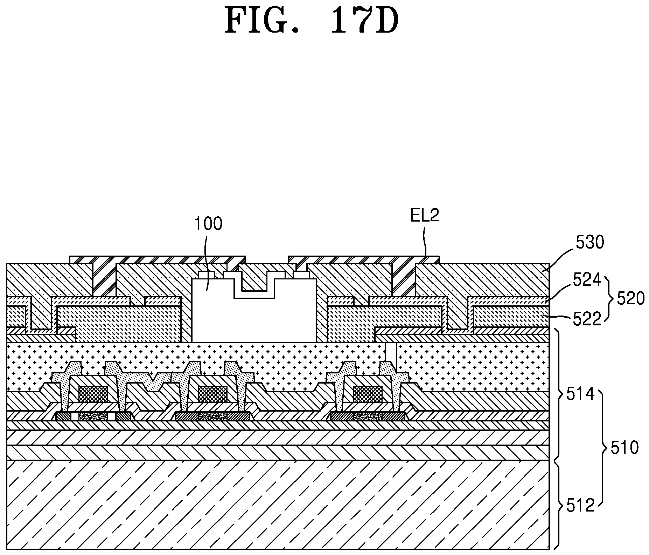

As illustrated in FIG. 17D, an insulating layer 530 for covering the light-emitting device 100 and at least part of the flexible partition wall 520 may be formed, and a second electrode pattern EL2 for electrically connecting the upper electrode of the light-emitting device 100 with the driving layer 514 may be formed. The second electrode pattern EL2 may be electrically connected to the first electrode pattern EL1 of the driving layer 514 through the metal layer 524 of the flexible partition wall 520. The insulating layer 530 may prevent infiltration of oxygen, moisture, and the like into the light-emitting device 100.

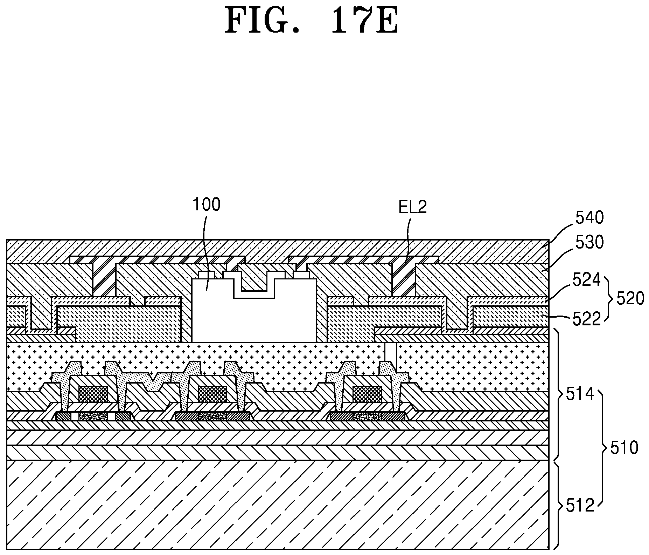

As illustrated in FIG. 17E, a planarization layer 540 may be formed on the insulating layer 530 and the second electrode pattern EL2. Then, a color conversion layer may be further formed.

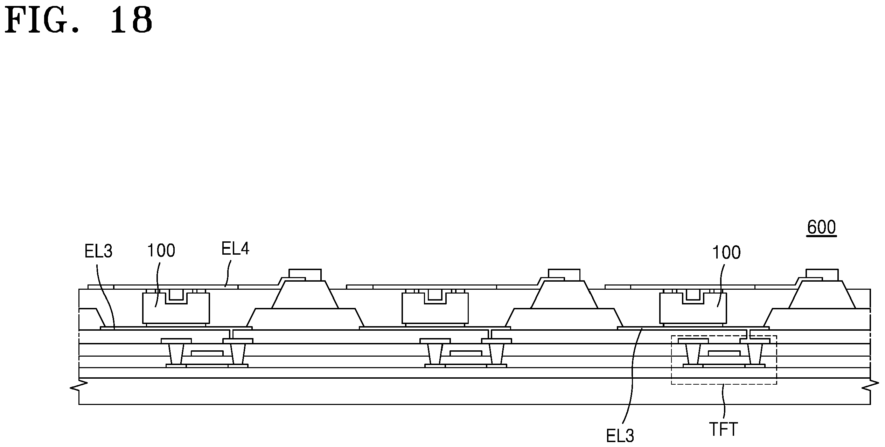

FIG. 18 is a view of a display apparatus 600 including the light-emitting device 100 according to another example embodiment. The display apparatus 600 of FIG. 18 may include a third electrode pattern EL3 arranged below the light-emitting device 100 and a fourth electrode pattern EL4 arranged above the light-emitting device 100. The third electrode pattern EL3 may be electrically connected to any one of the first and second electrodes 140 and 150 of the light-emitting device 100, and the fourth electrode pattern EL4 may be electrically connected to the other of the first and second electrodes 140 and 150 of the light-emitting device 100. Even when the second electrodes pattern EL4 is electrically connected to the second electrodes 150 of the light-emitting device 100, a defective cell of the light-emitting cells 120 of the light-emitting device 100 may not be electrically connected to the fourth electrode pattern EL4. For example, the second electrode of the defective cell may be electrically disconnected to the second electrode pattern EL4 in the manufacturing process of a display apparatus.

A display apparatus including the light-emitting devices 100, 100a, 100b, 100c, 100d, 100e, 100f, 100g, 100h, 100i, 100j, 100k, 1001, and 100m described above may be adopted in various electronic apparatuses. For example, the display apparatus may be applied to televisions (TVs), notebooks, mobile phones, smartphones, smart pads (PDs), portable media players (PMPs), personal digital assistants (PDAs), navigations, various wearable devices such as smart watches or head mount displays, and the like.

It should be understood that example embodiments described herein should be considered in a descriptive sense only and not for purposes of limitation. Descriptions of features or aspects within each example embodiment should typically be considered as available for other similar features or aspects in other embodiments.

While example embodiments have been described with reference to the figures, it will be understood by those of ordinary skill in the art that various changes in form and details may be made therein without departing from the scope as defined by the following claims and their equivalents.

## Claims

1. A light-emitting device comprising:
a plurality of light-emitting cells, each of the plurality of light-emitting cells being configured to independently emit light;
a common semiconductor layer provided on the plurality of light-emitting cells;
a first electrode provided on the common semiconductor layer; and
a plurality of second electrodes provided spaced apart from the first electrode and respectively provided on the plurality of light-emitting cells.

2. The light-emitting device of claim 1, wherein the plurality of light-emitting cells are provided spaced apart from each other on a first surface of the common semiconductor layer.

3. The light-emitting device of claim 1 or 2, wherein a width of each of the plurality of light-emitting cells is less than a width of the common semiconductor layer.

4. The light-emitting device of any preceding claim, wherein at least one of the plurality of light-emitting cells comprises a first semiconductor layer, an active layer, and a second semiconductor layer, which are sequentially provided, and optionally wherein each of the plurality of second electrodes is provided on the second semiconductor layer.

5. The light-emitting device of claim 4, wherein a material of the first semiconductor layer is the same as a material of the common semiconductor layer.

6. The light-emitting device of any preceding claim, wherein the first electrode is provided on a first surface of the common semiconductor layer on which the plurality of light-emitting cells are provided.

7. The light-emitting device of any preceding claim, wherein the first electrode extends toward an upper surface of at least one of the plurality of light-emitting cells along a side surface of at least one of the plurality of light-emitting cells.

8. The light-emitting device of any preceding claim, further comprising:
a first insulating layer provided between the first electrode and the plurality of light-emitting cells, and optionally wherein the first insulating layer is provided on each of the plurality of second electrodes.

9. The light-emitting device of any preceding claim, wherein the plurality of light-emitting cells are symmetrical with respect to a center axis of the light-emitting device.

10. The light-emitting device of any preceding claim, wherein the plurality of second electrodes are symmetrical with respect to a center axis of the light-emitting device.

11. The light-emitting device of any preceding claim, wherein the first electrode is symmetrical with respect to a center axis of the light-emitting device.

12. The light-emitting device of any preceding claim, wherein at least part of a space between the plurality of light-emitting cells is filled with the first electrode.

13. The light-emitting device of any preceding claim, wherein the first electrode is provided on a second surface of the common semiconductor layer that is different from a first surface of the common semiconductor layer on which the plurality of light-emitting cells are provided.

14. The light-emitting device of any preceding claim, wherein an outer circumferential surface of the common semiconductor layer has at least one of a circular shape, an oval shape, and a polygonal shape, and optionally wherein an outer circumferential surface of a combination of the plurality of light-emitting cells corresponds to the outer circumferential surface of the common semiconductor layer.

15. A display apparatus comprising:
a display layer comprising a plurality of light-emitting devices, the plurality of light-emitting devices including a light emitting device according to any preceding claim; and
a driving layer configured to drive the plurality of light-emitting devices, the driving layer comprising a plurality of transistors electrically connected to the plurality of light-emitting devices, respectively.
